(19) **Europäisches Patentamt / European Patent Office / Office européen des brevets**

(11) **EP 1 501 160 B1**

(12) **EUROPEAN PATENT SPECIFICATION**

(45) Date of publication and mention of the grant of the patent:
**23.04.2008 Bulletin 2008/17**

(51) Int Cl.:
*H01S 5/026* (2006.01)    *H01S 5/183* (2006.01)
*H01L 33/00* (2006.01)

(21) Application number: **04017281.9**

(22) Date of filing: **22.07.2004**

(54) **Electro-optical element**

Elektrooptisches Element

Elément électro-optique

(84) Designated Contracting States:
**DE FR GB**

(30) Priority: **23.07.2003   JP 2003278177**

(43) Date of publication of application:
**26.01.2005   Bulletin 2005/04**

(73) Proprietor: **Seiko Epson Corporation**
**Shinjuku-ku**
**Tokyo 163-0811 (JP)**

(72) Inventor: **Kaneko, Tsuyoshi**
**Suwa-shi**
**Nagano-ken 392-8502 (JP)**

(74) Representative: **Hoffmann, Eckart**
**Patentanwalt,**
**Bahnhofstrasse 103**
**82166 Gräfelfing (DE)**

(56) References cited:
EP-A- 0 760 544          US-A- 5 606 572
US-A- 6 001 664          US-A1- 2002 044 582
US-A1- 2002 185 588

- LIU Y ET AL: "Chip-scale integration of VCSEL, photodetector, and microlens arrays" PROCEEDINGS OF THE SPIE - THE INTERNATIONAL SOCIETY FOR OPTICAL ENGINEERING SPIE-INT. SOC. OPT. ENG USA, vol. 4652, 2002, pages 11-18, XP002341088 ISSN: 0277-786X
- PATENT ABSTRACTS OF JAPAN vol. 011, no. 376 (E-563), 8 December 1987 (1987-12-08) & JP 62 143486 A (TOSHIBA CORP), 26 June 1987 (1987-06-26)
- PATENT ABSTRACTS OF JAPAN vol. 2000, no. 12, 3 January 2001 (2001-01-03) -& JP 2000 269585 A (SAMSUNG ELECTRONICS CO LTD), 29 September 2000 (2000-09-29)

**Description**

The present invention relates to an electro-optical element.

A technique related to a light-emitting element (for example, a surface emitting semiconductor laser) has been developed (for example, JP-A-10-135568). Generally, if the light-emitting element is used for an optical communication or a light source for various kinds of sensors, an optical characteristic of the emitted light, for example the radiation angle or the wavelength of light, is required to be controlled.

As for the light-emitting element described above, a light-detecting part is stacked on the light-emitting element. This light-detecting part receives a part of the light emitted from the light-emitting element, thereby detecting its light volume. Therefore, the diameter of the light-detecting part is made smaller than that of a light-emitting region of the light-emitting element such that part of the light emitted from the light-emitting element can be introduced into the light-detecting part.

In the light-emitting element described above, the light-detecting part can be used as a normal light-receiving element, instead of or in addition to its usage for monitoring the power of the light generated in the light-emitting element. In this case, as above-mentioned, the diameter of the light-detecting part is generally made smaller than that of the light-emitting region of the light-emitting element, this results in too small a light receiving area of the light-detecting part, thereby causing an insufficient sensitivity.

US 2002/0185588 A1 discloses an electro-optical element according to the pre-characterizing portion of claim 1.

JP 2000-269585 A discloses an optical transceiver having a VCSEL as a light-emitting part and a light-receiving part formed on the VCSEL.

US 6,001,664 A discloses an electro-optical element comprising a monolithically integrated VCSEL and a photo detector for applications where the VCSEL and the photo detector require separate operation such as duplex serial data communications applications. The layers of a p-i-n photodiode are built on top of layers forming a VCSEL using a standard VCSEL process. The p-i-n layers are etched away in areas where VCSELs are to be formed and left where the photo detectors are to be formed. The VCSELs underlying the photo detectors are inoperable, and serve to recirculate photons back into the photo detector not initially absorbed.

EP 0 760 544 A1 discloses a grating-coupled laser as a light-emitting part formed on a first major surface of a semi-insulating InP substrate and a pin photodiode as a light-receiving part formed on a second major surface of the semi-insulating InP substrate.

The document LIU Y ET AL: "Chip-scale integration of VCSEL, photodetector, and microlens arrays" PROCEEDINGS OF THE SPIE, vol. 4652, 2002, pages 11-18, XP002341088 discloses forming a microlens array on an integrated VCSEL/Photdetector arrays. The microlens array is formed by depositing droplets of a lens-precursor liquid by means of a jet-printing technique.

US 2002/0044582 describes forming a lens on the emitting surface of a VCSEL wherein a liquid is deposited onto the emitting surface and subsequently cured.

It is an object of the invention to provide an electro-optical element including a light-emitting part and a light-receiving part where the efficiency of the light-receiving part is improved.

This object is achieved by an electro-optical element as claimed in claim 1. Preferred embodiments of the invention are defined in the dependent claims.

The term "optical member" as used in this text means a member, such as a lens or a deflection element, that has a function of changing an optical characteristic or the traveling direction of light. As for the "optical characteristic", for example, the wavelength, a deflection, the radiation angle or the like are exemplified. The term "optical surface" means a surface that allows light to pass through. The "optical surface" may be a exiting surface for the light traveling from the electro-optical element of the invention to the outside or an incident surface for the light traveling from the outside to the electro-optical element of the invention. The "outside" means a region excluding the electro-optical element of the invention.

In the present text, "light-receiving state" means a state where a light-receiving part is capable of receiving light irrespective of whether it actually does receive light or not.

Preferred embodiments of the invention will now be described with reference to the accompanying drawings, in which:

FIG. 1        is a sectional view schematically illustrating an electro-optical element;

FIG. 2        is a plan view schematically illustrating the electro-optical element shown in FIG. 1;

FIG. 3 to 10   are a sectional views schematically illustrating steps of a manufacturing method of the electro-optical element shown in FIG. 1;

FIG. 11          is a sectional view schematically illustrating an electro-optical element of an embodiment of the invention;

FIG. 12          is a plan view schematically illustrating the electro-optical element shown in FIG. 11;

FIG. 13          is a diagram of reflectance against wavelength;

FIG. 14          is a diagram schematically illustrating an optical module illustrating a use of the electro-optical element of the invention;

FIG. 15          is a diagram schematically illustrating an example of a drive circuit for an electro-optical element shown in FIG. 14;

FIG. 16          is a diagram schematically illustrating an optical transmitting device as another use of the invention; and

FIG. 17          is a diagram schematically illustrating a usage of a optical transmitting device.

**Basic Structure**

1. Construction of the electro-optical element

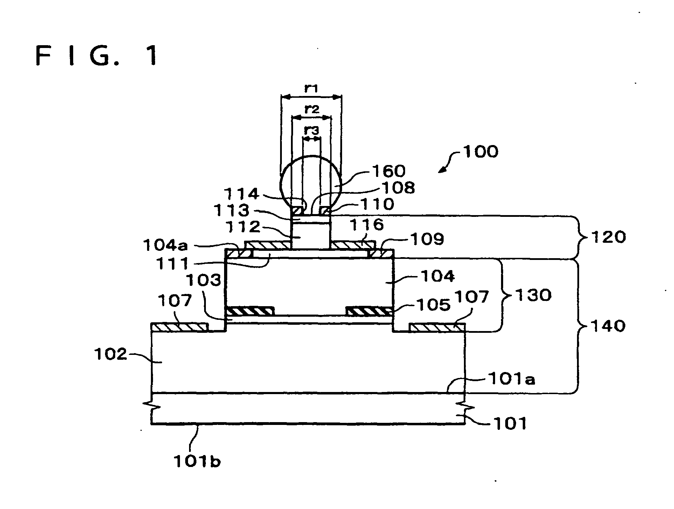

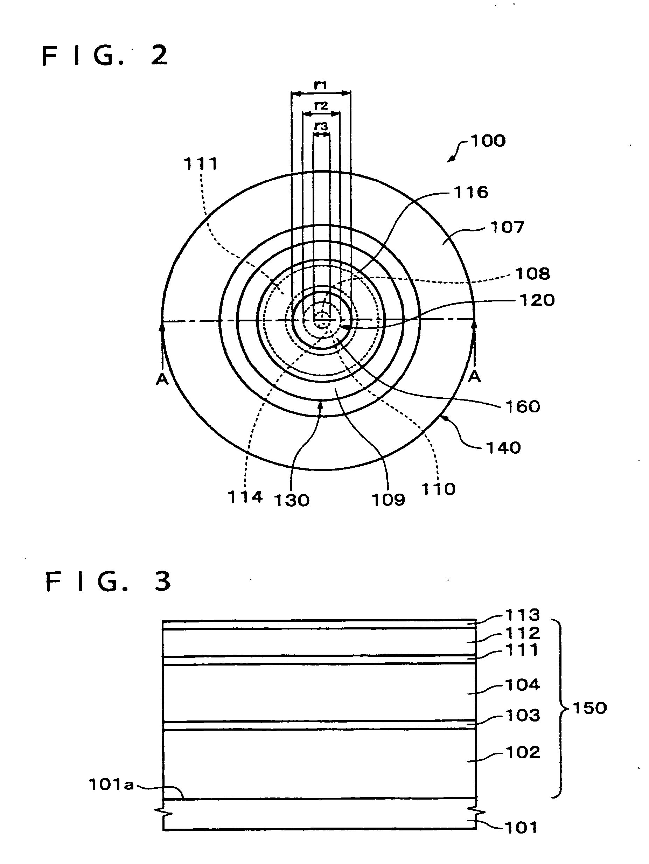

FIG. 1 is a sectional view schematically illustrating an electro-optical element 100. FIG. 2 is a plan view schematically illustrating the electro-optical element 100 in FIG. 1.

The electro-optical element 100, as shown in FIG. 1, includes a light-emitting part 140 and a light-receiving part 120. A case where the light-emitting part 140 is constituted by a surface emitting semiconductor laser and the light-receiving part 120 functions as a light-detecting part is described.

In this electro-optical element 100, laser light can be emitted from an optical surface 108 in the direction in which the light-emitting part 140 and the light-receiving part 120 are stacked upon one another. An optical member 160 is disposed at least on the optical surface 108. The light-emitting part 140, the light-receiving part 120, and other constructing elements will be described below.

Light-Emitting Part

The light-emitting part 140 is formed on a semiconductor substrate 101 (in this example, an n-type GaAs (Gallium Arsenide) substrate). The light-emitting part 140 forms a vertical resonator (hereafter, described as oscillator).

Also, the light-emitting part 140 may include a semiconductor stacked body 130 of columnar shape (hereafter, referred to as columnar part).

The light-emitting part 140 is constructed by forming, for example, a distributed reflection type multilayer film mirror 102 (hereafter, called a first mirror) including 40 pairs of an n-type $Al_{0.9}Ga_{0.1}As$ (aluminum-gallium-arsenide) layer and an n-type $Al_{0.15}Ga_{0.85}As$ layer alternately deposited one above another, an active layer 103 including an $Al_{0.3}Ga_{0.7}As$ barrier layer and a GaAs well layer that includes a quantum well structure of three layers, and a distributed reflection type multilayer film mirror 104 (hereafter, called a second mirror) including 29.5 pairs of a p-type $Al_{0.9}Ga_{0.1}As$ layer and a p-type $Al_{0.15}Ga_{0.85}As$ layer alternately deposited one above another in this order. The composition of each layer and the number of layers in the first mirror 102, the active layer 103, and the second mirror 104 are not limited to those mentioned above.

The second mirror 104 is p-type doped by carbon (C), for example. The first mirror 102 is n-type doped by silicon (Si), for example. Therefore, a pin diode is formed by the p-type second mirror 104, the undoped active layer, and n-type first mirror 102.

In the light-emitting part 140, the columnar part 130 is formed on the first mirror 102 by etching in a circular shape as viewed from an upper surface 104a of the second mirror 104. The columnar part 130 includes the second mirror 104, the active layer 103 and a part of the first mirror 102. Although the plan shape (sectional shape) of the columnar part 130 is a circular shape in this example, any other shape could be employed instead.

A current constriction layer 105 made of aluminum oxide is formed in a region of the second mirror 104 that faces the active layer 103. The current constriction layer 105 is formed in a circular ring-like shape in a cross-sectional plane parallel to a surface 101 a of the semiconductor substrate 101 in FIG. 1. This circular ring-like shape is concentric to the columnar part 130.

A first electrode 107 and a second electrode 109 are formed in the light-emitting part 140.

The first electrode 107 and the second electrode 109 are used to drive the light-emitting part 140. The second electrode 109 is formed on an upper surface 140a of the light-emitting part 140. Specifically, as shown in FIG.2, the first electrode 107 and the second electrode 109 have a ring-like shape in plan view. That is, the first electrode 107 is formed so as to surround the columnar part 130 and the second electrode 109 is formed so as to surround the light-receiving part 120. In other word, the columnar part 130 is formed inside the first electrode 107 and the light-receiving part 120 is formed inside the second electrode 109.

Although the first electrode 107 is formed on the first mirror 102 in this example, it may be formed on a backside 101 b of the semiconductor substrate 101. The same applies to the embodiment of the invention described later.

The first electrode 107 is made up of stacked layers of gold (Au) and an alloy of Au and germanium (Ge), for example. The second electrode 109 is made up of stacked layers of platinum (Pt), titanium (Ti), and Au. Current is injected into the active layer 103 by the first electrode 107 and the second electrode 109. The material forming the first electrode 107 and that forming the second electrode 109 are not limited to those mentioned above. For example, an alloy of Au and zinc (Zn) is applicable.

Light-Receiving Part

The light-receiving part 120 is formed on the light-emitting part 140 and includes the optical surface 108. Part of the upper surface of the light-receiving part 120 constitutes the optical surface 108. At least the upper part of the light-receiving part 120 is columnar.

The light-receiving part 120 includes a first contact layer 111, a light absorption layer 112, and a second contact layer 113. The first contact layer 111 is formed on the second mirror 104 of the light-emitting part 140. The light absorption layer 112 is formed on the first contact layer 111. The second contact layer 113 is formed on the light absorption layer 112. As for the light-receiving element part 120, the case where a plan shape of the first contact layer 111 is larger than that of the light absorption layer 112 and that of the second contact layer 113 is shown (refer to FIG. 1 and FIG. 2). The first contact layer 111 contacts the second electrode 109 and a third electrode 116. A part of the third electrode 116 is formed on the second electrode 109. Therefore, a side surface of the first contact layer 111 contacts the second electrode 109 and the upper surface of the second electrode 109 contacts the third electrode 116.

The first contact layer 111 can be an n-type GaAs layer, for example. The light absorption layer 112 can be an undoped GaAs layer, for example. The second contact layer 113 can be a p-type GaAs layer. Specifically, the first contact layer 111 is p-type doped by C, for example. The second contact layer 113 is n-type doped by Si, for example. Therefore, a pin diode is formed by the n-type first contact layer 111, the undoped light absorption layer 112, and p-type the second contact layer 113.

The third electrode 116 and a fourth electrode 110 are formed in the light-receiving part 120. The third electrode 116 and the fourth electrode 110 are used to drive the light-receiving part 120. The same material as that of the first electrode 107 can form the third electrode 116. The same material as that of the second electrode 109 can form the fourth electrode 110.

The fourth electrode 110 is formed on an upper surface of the light-receiving part 120 (on the second contact layer 113). An opening 114 is provided in the fourth electrode 110. The bottom of the opening 114 is the optical surface 108. Therefore, changing the plan shape and size of the opening 114 changes the shape and size of the optical surface 108. As shown in FIG. 1, the optical surface 108 is shown to have a circular shape as an example.

Optical Member

In the electro-optical element 100, the optical member 160 is disposed at least on the optical surface 108. Specifically, as shown in FIG.1, the optical member 160 is disposed on the upper surface of the light-receiving part 120. A case where the electro-optical element 160 functions as a lens will be described. In this case, the light generated in the light-emitting part 140 emits from the optical surface 108 and is condensed by the optical member 160 and emitted to the outside.

The optical member 160 is formed by curing a liquid material (for example, a precursor of an ultraviolet (UV) curable resin or a thermosetting resin) that is capable of curing by exposure to energy, such as heat, light or the like. Examples of the UV curable resin include an acrylic-type UV curable resin and an epoxy-type resin. For the thermosetting resin, a thermosetting polyimide-type resin or the like are exemplified.

The precursor of the UV curable resin is cured by irradiation with UV light in a short time. This makes it possible to cure without passing through a process such as heating that could easily damage the light-emitting part and/or the light-receiving part. Consequently, forming the optical member 160 by employing the precursor of UV curable resin, influence on the optical element can be lessened.

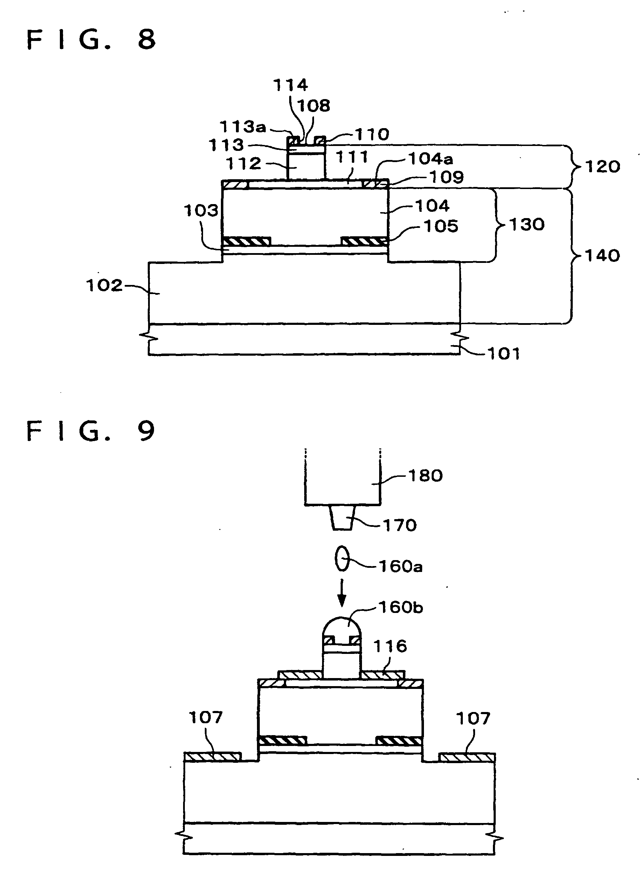

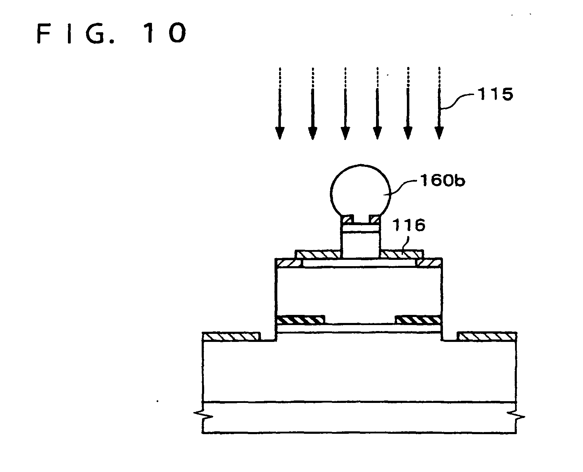

Specifically, the optical member 160 is disposed as follows (refer to FIG. 9 and FIG. 10): A liquid drop 160a made of the liquid material is ejected at least to the optical surface 108 (here, on the top of the light-receiving part 120) so as to form a precursor of the optical member 160b. Then, the precursor of the optical member 160b is cured. A method for forming the optical member 160 will be described later.

The optical member 160 has a shape like a cut sphere. Therefore, the optical member 160 can be used as a lens or a deflection element. For example, shaping the upper surface of the light-receiving part 120 as a circle, the three dimensional shape of the optical member 160 can be formed like the cut sphere. Alternatively, shaping the upper surface of the light-receiving part 120 as an oval, the three dimensional shape of the optical member 160 can be formed like a cut oval body.

Here, the term "cut sphere " means a shape obtained by cutting a sphere with a plane. The "sphere" is not necessarily a perfect sphere but also includes a shape similar to the sphere.

A cross-sectional surface that is obtained by cutting the optical member 160 with a plane being parallel to the optical surface 108 is a circle and the optical surface 108 is circular. This enables, as shown in FIG. 1 and FIG. 2, the greatest diameter r1 of the cross-sectional surface that can be obtained by cutting the optical member 160 with a plane being parallel to the optical surface 108 (the diameter r1 of the projection of the optical member 160 onto the optical surface 108) to be larger than the greatest diameter r2 of the upper surface of the light-receiving part 120 and the greatest diameter r3 of the optical surface 108 because at least the upper part of the light-receiving part 120 is columnar.

Whole Construction

The electro-optical element 100 has an npnp structure as a whole, which is formed by the n-type first mirror 102 and the p-type second mirror of the light-emitting part 140, and the n-type first contact layer 111 and the p-type second contact layer 113 of the light-receiving part 120. By interchanging the p-type and n-type in these layers, a pnpn structure can be formed as a whole. Alternatively, not shown in the Figures, by interchanging p-type and n-type of the layers in either the light-emitting part 140 or the light-receiving part 120, the light-emitting part 140 and the light-receiving part 120 can be formed as an npn or pnp structure as a whole. This applies to the embodiment described later in the same manner.

The light-receiving part 120 has a function of monitoring the output of light generated in the light-emitting part 140. Specifically, the light-receiving part 120 converts the light generated in the light-emitting part 140 to a current. The output of the light generated in the light-emitting part 140 is detected as the value of this current.

More specifically, in the light-receiving part 120, a part of the light generated in the light-emitting part 140 is absorbed in the light absorption layer 112. The absorbed light causes a light excitation in the light absorption layer 112, thereby producing electrons and holes. By an electric field applied from outside of the element, the electrons are moved to the third electrode 116, and the holes are moved to the fourth electrode respectively. As a result, a current flows from the first contact layer 111 to the second contact layer 113.

Principally a bias voltage applied to the light-emitting element 140 determines the light output of the light-emitting part 140. Especially, if the light-emitting element 140 is a surface emitting semiconductor laser, the light output of the light-emitting part 140 fluctuates widely depending on the surrounding temperature of the light-emitting part 140 or the lifespan of the light-emitting part 140. Therefore, in the light-emitting part 140, it is required to maintain the light output at a predetermined value as follows: monitoring the light output of the light-emitting part 140, the voltage to be applied to the light-emitting part 140 is controlled based on the value of the current produced in the light-receiving part 120 so as to adjust the value of the current flowing in the light-emitting part 140. As a result, the light output of the light-emitting part 140 is maintained substantially constant. A control scheme by which the light output of the light-emitting part 140 is fed back to voltage applying means for applying voltage to the light-emitting part 140 can be carried out by using an external electric circuit (a drive circuit, not shown).

Although the electro-optical element 100 has been described to be a surface emitting semiconductor laser, any electro-optical element other than a surface emitting semiconductor laser is applicable. For example, a semiconductor light emitting diode or the like may be used. This applies to the electro-optical element described in the following in the same manner.

2. Operation of the electro-optical element

The general operation of the electro-optical element 100 will be described below. A driving method for the surface emitting semiconductor laser described below is an example.

A forward voltage is applied to the pin diode defined between the first electrode 107 and the second electrode 109. A recombination of electrons and holes occurs in the active layer 103 of the light-emitting part 140, thereby generating light due to the recombination. Then, an induced emission occurs while the light travels forward and backward from the second mirror 104 to the first mirror 102, thereby amplifying the intensity of the light. If the optical gain exceeds the optical loss, a laser oscillation occurs such that laser light emits from the upper surface 104a of the second mirror 104 and is incident on the first contact layer 111 of the light-receiving part 120.

In the light-receiving part 120, the light that has been incident on the first contact layer 111 is incident on the light absorption layer 112. As the result that a part of the incident light is absorbed in the light absorption layer 112, light excitation occurs in the light absorption layer 112, thereby producing the electrons and hole pairs. By the electric field applied from the outside of the optical element, the electrons are moved to the third electrode 116, and the holes are moved to the fourth electrode 110. As a result, a current (a light-induced current) flows from the first contact layer 111 to the second contact layer 113. The light output of the light-emitting part 140 can be detected by measuring the value of that current. The light that has passed through the light-receiving part 120 is emitted from the optical member 160, in which the radiation angle of the light is reduced.

3. Method for manufacturing the electro-optical element

Next, an example of the method of manufacturing the electro-optical element 100 will be described with reference to FiGs. 3 through 10. FIGs. 3 through 10 are sectional views schematically illustrating respective process steps of the method. Each of the sectional views corresponds to a sectional view in FIG. 1.

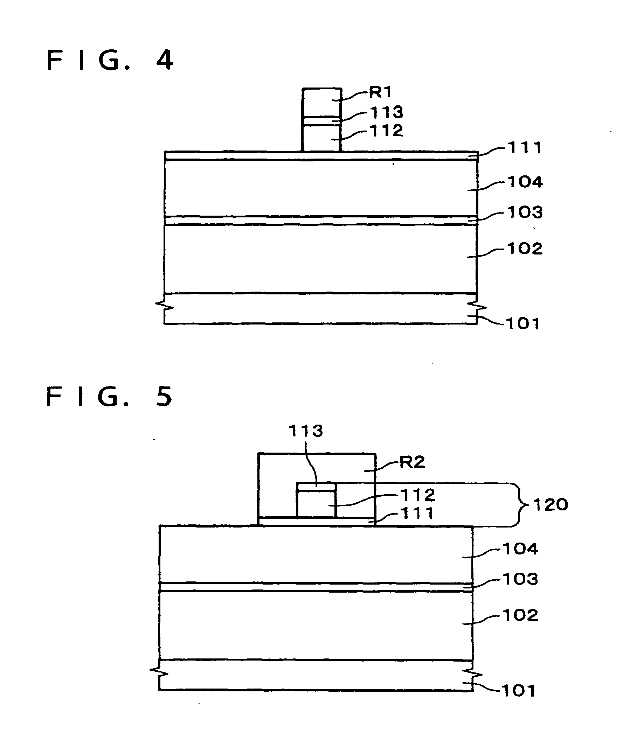

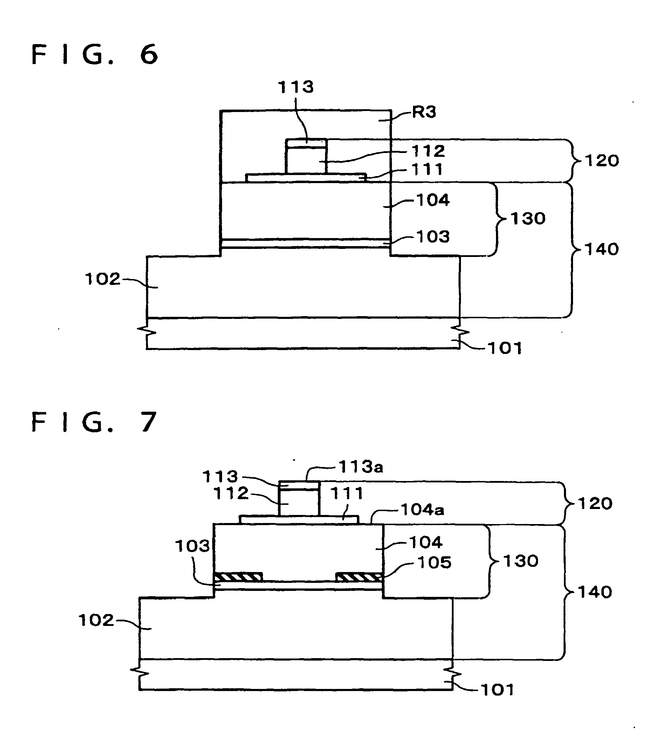

(1) At the first, a semiconductor multilayer film 150 is grown epitaxially on a surface 101 a of the semiconductor substrate 101, including the n-type GaAs, by changing and controlling its composition as shown in FIG. 3 (refer to FIG. 3). The semiconductor multilayer film 150 is made of followings: the first mirror 102 including 40 pairs of an n-type $Al_{0.9}Ga_{0.1}As$ layer and an n-type $Al_{0.15}Ga_{0.85}As$ layer alternately deposited; the active layer 103 including an $Al_{0.3}Ga_{0.7}As$ barrier layer and a GaAs well layer that includes a quantum well structure of three layers; the second mirror 104 including 29.5 pairs of a p-type $Al_{0.9}Ga_{0.1}As$ layer and a p-type $Al_{0.15}Ga_{0.85}As$ layer alternately deposited; the first contact layer 111 including n-type GaAs; and the second contact layer 113 including p-type GaAs. Depositing those layers one after another, the semiconductor multilayer film 150 is formed (refer to FIG. 3).
In the growing of the second mirror 104, at least one layer that is close to the active layer 103 is formed as an AlAs layer or an AlGaAs layer containing 95 atom% or more Al. This layer will be oxidized later so as to become the current constriction layer 105 (refer to FIG. 7). It is preferable that the carrier density is high in the vicinity of a part of the second mirror 104 where the second mirror 104 contacts at least the second electrode 109 so as to easily take an ohmic contact-connection to the second electrode 109 in a later process in which the second electrode 109 is formed. In a similar way, it is preferable that the carrier density is high in the vicinity of a part of the first contact layer 111 where the first contact layer 111 contacts at least the third electrode layer 116 so as to easily take the ohmic contact-connection to the third electrode 116.
The temperature for the epitaxial growing is determined depending on the growing method, the raw material, the type of the semiconductor substrate 101, the type and thickness of the semiconductor multilayer film 150 to be formed, and the carrier density. Generally, 450 °C to 800 °C is preferred. The processing time for the epitaxial growing is determined in consideration of the same factors as those considered for the temperature. As for a method for the epitaxial growing, a metal-organic vapor phase epitaxy (MOVPE), a molecular beam epitaxy (MBE), or a liquid phase epitaxy (LPE) can be employed.
(2) Next, the second contact layer 113 and the light absorption layer 112 are patterned to a predetermined shape (refer to FIG. 4).
At first, a photoresist (not shown) is applied onto the semiconductor multilayer film 150. The photoresist is patterned by a photolithographic method so as to form a resist layer R1 of a predetermined pattern.
Next, the second contact layer 113 and the light absorption layer 112 are etched by a dry-etching method, for example, using the resist layer R1 as a mask. Accordingly, the second contact layer 113 and the light absorption layer 112 having the same plan shape (shape in plan-view) as the second contact layer 113 are formed. Then, the resist R1 is removed.
(3) Next, the first contact layer 111 is patterned to a predetermined shape (refer to FIG. 5). Specifically, at first, a photoresist (not shown) is applied onto the first contact layer 111. The photoresist is patterned by the photolithographic method so as to form a resist layer R2 of a predetermined pattern (refer to FIG. 5).
Next, the first contact layer 111 is etched by a dry-etching method, for example, using the resist layer R2 as a mask. Accordingly, the light-receiving part 120 is formed as shown in FIG.7. Then, the resist R2 is removed. The light-receiving part 120 includes the second contact layer 113, the light absorption 112, and the first contact layer 111.
A plan shape of the first contact layer 111 can be formed larger than that of the second contact layer 113 and the light absorption layer 112.
In above-mentioned processes, the first contact layer 111 is patterned after the patterning of the second contact layer 113 and the light absorption layer 112. Alternatively, the second contact layer 113 and the light absorption layer 112 may be patterned after patterning of the first contact layer 111.
(4) Next, the light-emitting part 140 including the columnar part 130 is formed by patterning (refer to FIG. 6). Specifically, at first, a photoresist (not shown) is applied onto the second mirror 104. The photoresist is patterned by the photolithographic method so as to form a resist layer R3 of a predetermined pattern (refer to FIG. 6).
Next, the second mirror 104, the active layer 103, and a part of the first mirror 102 are etched by the dry-etching method, for example, using the resist layer R3 as a mask, thereby forming the columnar part 130 as shown in FIG. 6. A resonator including the columnar part 130 (the light-emitting part 140) is formed by processes described above. Namely, a stacked structure made up of the light-emitting part 140 and the light-receiving part 120 is formed. Then, the resist layer R3 is removed.

As above-mentioned, the light-receiving part 120 is formed prior to the formation of the columnar part 130. Alternatively, the light-receiving part 120 may be formed after the formation of the columnar part 130.

(5) Next, the semiconductor substrate 101 on which the columnar part 130 has been formed by the processes described above is subjected to, for example, water vapor approximately at 400 °C so as to form the current constriction layer 105 by oxidizing the layer containing a high amount of Al in the second mirror 104 from its side (refer FIG. 7).

The oxidation rate depends on the temperature of a furnace, the supply amount of water vapor, and the Al proportion and the thickness of the layer to be oxidized (the layer containing a high Al proportion described above). In a surface light-emitting laser including a current constriction layer formed by oxidization, a current flows only in a part where the current constriction layer has not been formed (a part where the oxidization has not been done) at the time of driving. Therefore, controlling the area where the current constriction layer 105 is formed in its forming process by the oxidation, the current density can be controlled.

It is preferable that the diameter of the current constriction layer 105 is adjusted such that a large portion of the light emitted from the light-emitting part 140 is incident on the first contact layer 111.

(6) Next, the second electrode 109 is formed on the upper surface 104a of the second mirror 104. Then, the fourth electrode 110 is formed on the top of the light-receiving part 120 (on the upper surface 113a of the second contact layer 113) (refer to FIG. 8).

At first, prior to the forming of the second electrode 109 and the fourth electrode 110, the upper surface 104a of the second mirror 104 and the upper surface 113a of the second contact layer 113 are cleaned by a plasma treatment method or the like, if necessary. This enables an element having more stable characteristic to form.

Next, a deposited multiple layer of, for example, Pt, Ti, and Au (not shown) is formed by a vacuum deposition method for example. Then, the deposited multiple layer excluding a predetermined position is removed by a liftoff method so as to form the second electrode 109 and the fourth electrode 110. In this process, a part to which the deposited multiple layers described above is not provided is formed on the upper surface 113a of the second contact layer 113. This part forms the opening 114 and its bottom is the optical surface 108. In above-mentioned process, the dry-etching method also can be used instead of the liftoff method. Additionally, while the second electrode 109 and the fourth electrode 110 are patterned at once in above-mentioned process, the second electrode 109 and the fourth electrode 110 can be patterned singly.

(7) Next, in the same manner, patterning the deposited multiple layer made up of, for example, Au and an alloy of Au and Ge, the first electrode 107 is formed on the first mirror 102 of the light-emitting part 140, and the third electrode 116 is formed on the first contact layer 111 of the light-receiving part 120 (refer to FIG. 9).

Then, an annealing is done. The temperature of the annealing depends on the electrode material. As for the electrode material used, the temperature is usually approximately 400 °C. The first electrode 107 and the third electrode 116 are formed by processes described above (refer to FIG. 9). The first electrode 107 and the third electrode 116 can be formed by the patterning at once or separately.

The above-mentioned processes achieve the electro-optical element 100 including the light-emitting part 140 and the light-receiving part 120.

(8) Next, the optical member 160 is formed on the light-receiving part 120 (refer to FIGS. 9 and 10). A case where a part of the optical member 160 is formed on the optical surface 108, and another part of the optical member 160 is formed on the light-receiving part 120 with the fourth electrode 110 (refer to FIG. 1) will be described.

At the first, a treatment for adjusting a wetting angle of the optical member 160 is carried out on the upper surface of the light-receiving part 120 (on the surface of the second contact layer 113 and the optical surface 108), if necessary. This process makes it possible to achieve an optical member precursor 160b in a predetermined shape if the liquid material is applied onto the upper surface of the light-receiving part 120 in a process described later, thereby achieving an optical member having a predetermined shape (refer to FIGS. 9 and 10).

Then, a liquid drop 160a of the liquid material is ejected toward the optical surface 108 by an inkjet method for example. Examples of inkjet ejection methods include (1) a method where bubbles are created in the liquid (here, the liquid for optical member precursor) by heat so as to generate pressure and eject the liquid, and (2) a method that generates pressure by a piezoelectric element to eject the liquid. Considering the controllability of pressure method (2) is preferable.

Alignment between a nozzle position of an inkjet head and the ejecting position of the liquid is carried out by a known image recognition technique that is used in an exposure process or an inspection process of a general manufacturing processes of semiconductor integrated circuits. For example, the alignment between the position of a nozzle 170 of an inkjet head 180 and the position of the optical surface 108 is carried out as shown in FIG. 9. After the alignment, the inkjet head 180 ejects the liquid drop 160a of the liquid material by controlling the voltage applied to the inkjet head 180. Accordingly, the optical member precursor 160b is formed on the upper surface of the light-receiving part 120 as shown in FIG. 9.

In this case, as shown in FIG. 9, at the time when the liquid drop 160a ejected from the nozzle 170 lands on the upper surface of the light-receiving part 120, the liquid material 160b is deformed by surface tension, thereby positioning the liquid material 160b at the center of the upper surface of the light-receiving part 120. Accordingly, the position is automatically adjusted.

Also, in this case, the optical member precursor 160b (refer to FIG. 10) has a shape and size in accordance with the shape and size of the upper surface of the light-receiving part 120, the ejecting amount of the liquid drop 160a, the surface tension of the liquid drop 160a, and the surface tension between the upper surface of the light-receiving part 120 and the liquid drop 160a. Therefore, controlling these factors, the shape and size of the optical member 160 that is finally achieved (refer FIG. 1) can be controlled, thereby increasing the freedom of the lens design.

After completion of the processes described above, as shown in FIG. 10, the optical member precursor 160b is cured by an energy ray (for example, UV light) so as to completed formation of the optical member 160 on the upper surface of the light-receiving part 120 (refer to FIG. 1). The optimum wavelength and irradiation amount of the UV light depends on the material of the optical member precursor 160b. For example, if a precursor of an acrylic-type UV curable resin is used for forming the optical member precursor 160b, the cure is done by UV light with a wavelength of approximately 350 nm and an intensity of 10mW for an irradiation time of 5 minutes. The above-mentioned processes achieve the electro-optical element 100 as shown in FIG. 1.

4. Beneficial Effects

The electro-optical element 100 includes beneficial effects as follows.

(A) Firstly, by providing the optical member 160 at least on the optical surface 108, the light generated in the light-emitting part 140 can be emitted to the outside after adjusting its radiation angle. For example, by means of the optical member 160, the radiation angle of the light generated in the light-emitting part 140 can be reduced. Accordingly, the light emitted from the electro-optical element 100 can be easier introduced into an optical waveguide such as an optical fiber or the like.

(B) Secondly, the size and shape of the optical member 160 can be strictly controlled. As mentioned above in the process (8), in order to form the optical member 160, the optical member precursor 160b is formed on the upper surface of the light-receiving part 120 (refer to FIGs. 8 and 9). As long as the liquid material making the optical member precursor 160b does not wet a side of the light-receiving part 120, the surface tension of the liquid material principally acts on the optical member precursor 160b. Therefore, the shape of the optical member precursor 160b can be controlled by controlling the amount of the liquid material (the liquid drop 160a) used for forming the optical member 160. This makes it possible to form an optical member 160 whose shape is more strictly controlled. As a result, an optical member 160 having a predetermined shape and size can be achieved.

(C) Thirdly, the placement position of the optical member 160 can be strictly controlled. As mentioned above, the optical member 160 is formed by following steps. At the first, by ejecting the liquid drop 160a onto the upper surface of the light-receiving part 120, the optical member precursor 160b is formed. Then, the optical member precursor 160b is cured (refer to FIGs. 9 and 10). Generally, it is difficult to strictly control the position on which the ejected liquid lands. However, this method makes it possible to form the optical member 160 on the upper surface of the light-receiving part 120 without a positioning. Specifically, simply ejecting the liquid drop 160a onto the upper surface of the light-receiving part 120, the optical member precursor 160b can be formed without the positioning. This enables the optical member 160 whose placement position is controlled to be formed simply and at a high yield rate. Especially, if the liquid drop 160b is ejected by the inkjet method, it can be ejected to a more accurate position, thereby enabling the optical member 160 whose placement position is more precisely controlled to be formed simply and at a high yield rate. Also, by employing the inkjet method, the ejecting amount of the liquid drop 160b can be controlled at a unit of a picoliter order, thereby enabling a precise structure to form accurately.

(D) Fourthly, feeding back a result of a part of the output light of the light-emitting part 140 monitored in the light-receiving part 120 to the drive circuit, an output fluctuation due to temperature or the like can be corrected, thereby achieving a stable light output.

**Embodiment of the Invention**

<u>1. Construction of the electro-optical element.</u>

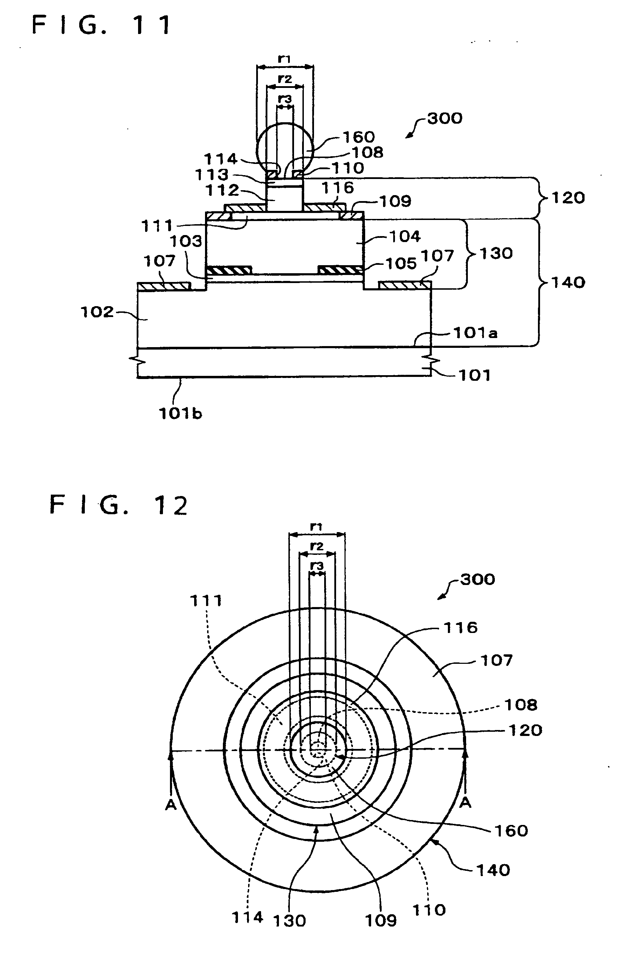

FIG. 11 is a sectional view schematically illustrating an electro-optical element 300 according to an embodiment of the invention. FIG. 12 is a plan view schematically illustrating the electro-optical element 300 shown in FIG. 11. In this embodiment, in the same manner as with the electro-optical element 100 described above, a case where the light-emitting part 240 is a surface emitting semiconductor laser and the light-receiving part 220 functions as a light-detecting part is described.

The electro-optical element 300 according to the embodiment includes the same construction as that of the electro-optical element 100 described above. Therefore, like elements are denoted by the same reference signs, and are not described in detail again.

In the electro-optical element 300, the light-receiving part 120 additionally has a function to absorb light that is incident on the optical surface 108 after having passed through the optical member 160 from the outside and to converts it to a current. An optical thickness d is represented by the following formula (1), where A is a design wavelength of the light-emitting part:

$$d = m\lambda/2 \tag{1}$$

(m: natural number greater than or equal to one)

In the electro-optical element 300 of the embodiment, the optical thickness d of the light-receiving part 120 is the sum of the each optical thickness of the first contact layer 111, the light absorption layer 112, and the second contact layer 113 as shown in FIG. 11. Since the optical thickness is a value that is calculated by multiplying the actual film thickness of a layer by the refractive index, for example, in a case of a layer where the optical thickness is $\lambda/4$, the refractive index n is 2.0 and the light wavelength is $\lambda$, the actual film thickness of the layer is equal to (optical thickness) / (refractive index n). Therefore, $(\lambda/4)/2.0 = 0.125\lambda$. In this embodiment, "thickness" means the actual thickness of the layer.

Setting the optical thickness d of the light-receiving part 120 so as to satisfy the formula (1) described above, light of a specified wavelength can be absorbed efficiently in the light absorption layer 112 of the light-receiving part 120.

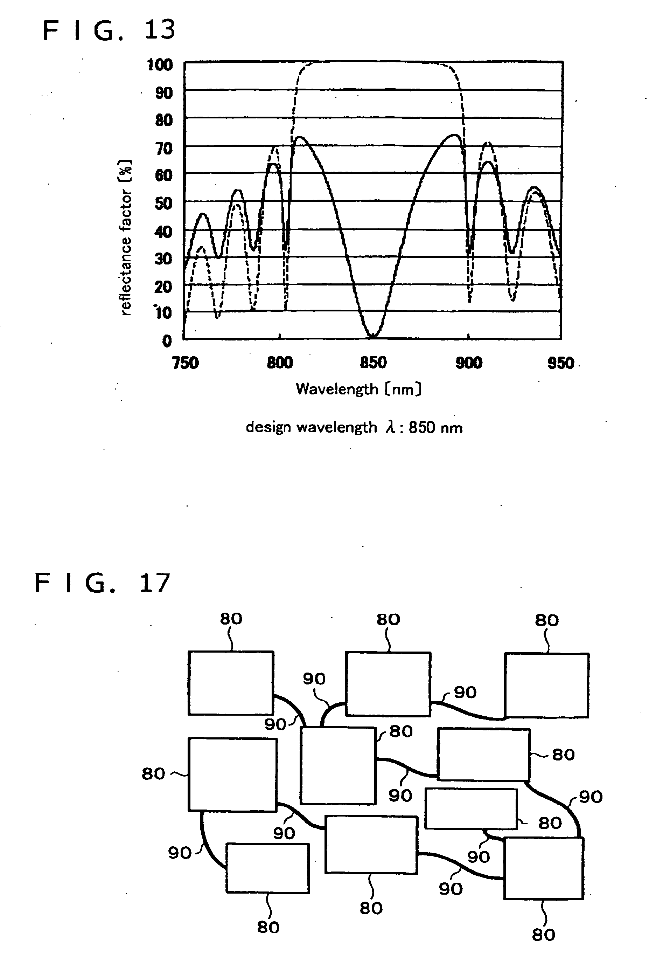

In the electro-optical element 300 of the embodiment, FIG. 13 shows the reflectance (solid line) of the light-receiving part 120 for light that is incident on the light-receiving part 120 from the optical surface 108 and the reflectance (broken line) of the second mirror 104 for light that is incident on the second mirror 104 from the active layer 103. The design wavelength $\lambda$ is 850 nm. The optical thickness d of the light-receiving part 120 is $2\lambda$. The second mirror 104 of the light-emitting part 140 is made up of 29.5 pairs of a p-type $Al_{0.9}Ga_{0.1}As$ layer having the optical thickness of $\lambda/4$ and a p-type $Al_{0.15}Ga_{0.85}As$ layer having the optical thickness of $\lambda/4$ alternately deposited one after another.

Referring to FIG. 13, if light of the design wavelength $\lambda$ is incident on the second mirror 104 from the active layer 103, the reflectance of the light is nearly 100 %. On the other hand, if light of the design wavelength $\lambda$ is incident on the light-receiving part 120 from the optical surface 108, the reflectance of the light is nearly 0 %. Therefore, if the light of the design wavelength $\lambda$ is incident on the light-receiving part 120 from the optical surface 108, most of the light is absorbed in the light-receiving part 120.

From the above-mentioned results, according to the electro-optical element 300, setting the optical thickness d of the light-receiving part 120 so as to satisfy the formula (1), the light can be absorbed efficiently in the light absorption layer 112 without change of the construction of the light-emitting part 140. Therefore, the light that is incident on the optical surface 108 from the outside can be introduced efficiently into the light absorption layer 112 of the light-receiving part 120.

<u>2. Operation of the electro-optical element.</u>

In the electro-optical element 300 of the embodiment, the light-receiving part 120 absorbs the light from the outside and converts it to current as described above. In this case, the light from the outside is incident on the optical member 160. Then, the light is incident on the light-receiving part 120 from the optical surface 108. The light is absorbed by the light absorption layer 112 and converted to current. With the value of the current obtained there, an amount of the light that is entered from the outside can be detected. On the other hand, the light generated in the light-emitting part 140 passes through the light-receiving part 120. Then, the light is emitted from the optical member 160 in which its radiation angle is reduced. Operations other than described above are the same as those of the electro-optical element 100, and are not further described here.

3. Beneficial Effect.

The electro-optical element 300 and the method for manufacturing it according to the embodiment have the beneficial effect that is substantively the same as that of the electro-optical element 100 and that of the method for manufacturing that.

Additionally, according to the electro-optical element 300 of the embodiment, the light-receiving part 120 absorbs the light from the outside and converts it to current. In this case, since the optical member 160 is formed on the optical surface 108, a wide range of light can be incident on the optical surface 108.

The optical member 160 is formed as follows. At the first, ejecting the liquid drop onto the upper surface of the light-receiving part 120, the optical member precursor 160b is formed. Then, the optical member precursor 160b is cured.

Accordingly, as shown in FIGs. 11 and 12, this enables the greatest diameter, namely diameter r1, of the cross-section of the optical member 160 to be larger than the diameter r2 of the upper surface of the light-receiving part 120. This makes it possible to increase the diameter of the optical member 160 larger, thereby enabling a wider range of light to be incident on the optical surface 108.

In the electro-optical element 300 of the embodiment, the first electrode 107 and second electrode 109 formed in the light-emitting part 140 have a ring-like plan shape (refer to FIG. 12). If the light-emitting part 140 is a surface emitting semiconductor laser, since the first electrode 107 and second electrode 109 have the ring-like plan shape, current can flow uniformly in the light-emitting part 140.

On the other hand, sectional views of the first electrode 107, the second electrode 109, the columnar part 130, and the light-receiving part 120 are like concentric circles. More specifically, the columnar part 130 and the second electrode 109 are formed inside the first electrode 107 and the light-receiving part 120 is formed inside the second electrode 109. Therefore, as shown in FIG. 11, the optical surface 108 formed on the upper surface of the light-receiving part 120 is smaller than the cross-sectional surface of the light-emitting part 140. As a result, this makes it difficult to introduce the light from the outside through the optical surface 108.

However, in the electro-optical element 300 of the embodiment, with providing the optical member 160 on the optical surface 108, the light from the outside can be introduced efficiently through the optical surface 108. Consequently, while the first electrode 107 and second electrode 109 have the plan shape of the ring-like, the light can be introduced efficiently through the optical surface 108.

**Examples of Uses of the Electro-Optical Element**

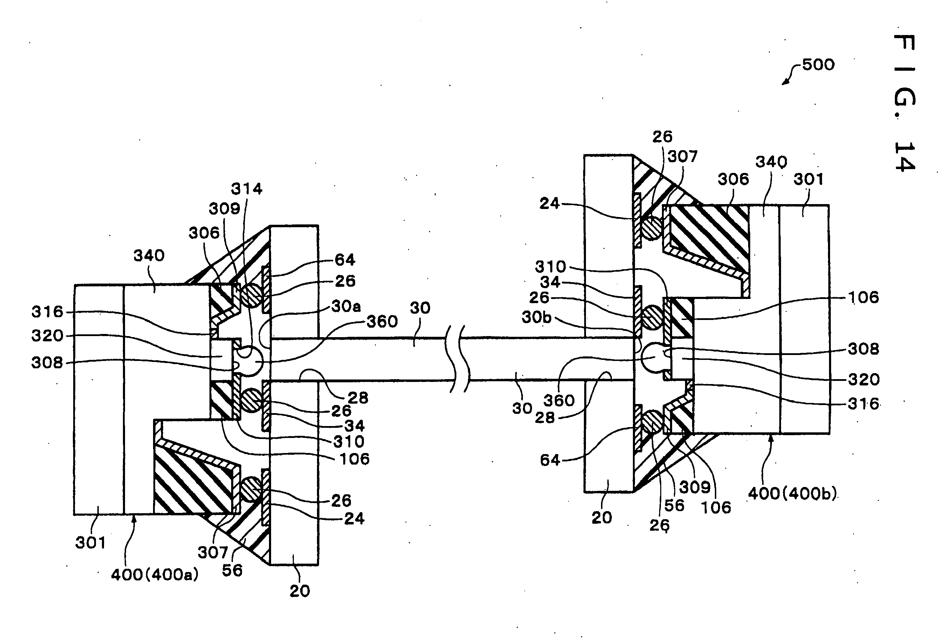

FIG. 14 is a diagram schematically illustrating an optical module 500 according to a first example. The optical module 500 includes a first electro-optical element 400a and a second electro-optical element 400b (both referred to as the electro-optical element 400 where a structure or function common to both is addressed), a semiconductor chip 20, and an optical waveguide (an optical fiber 30). In the electro-optical element 400, a light-receiving part 320 includes a first function of converting the light that is incident on an optical surface 308 from a light-emitting part 340 to current and a second function of converting the light that is incident on an optical surface 308 from an optical member 360 to current in the same manner as with the electro-optical element 300 of the embodiment.

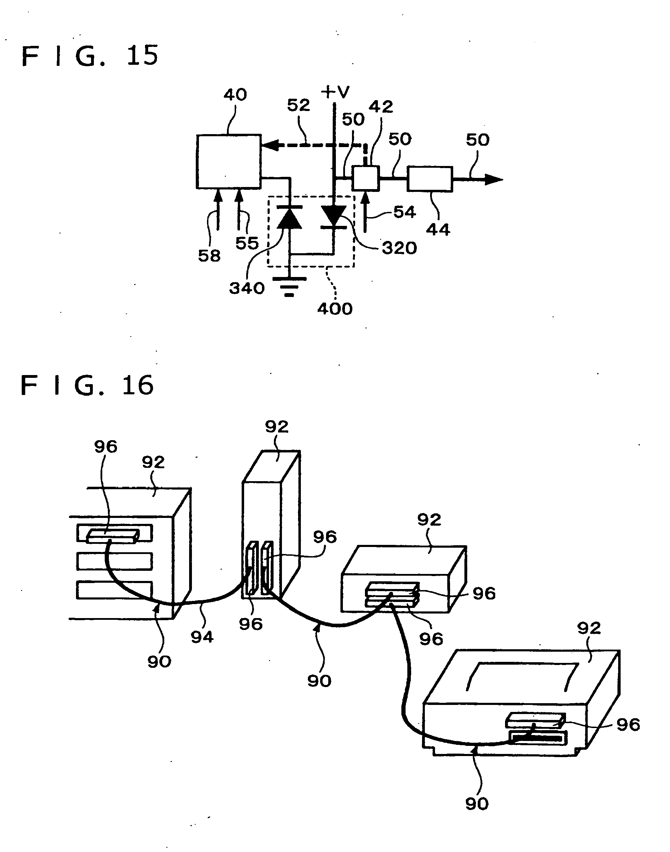

In the optical module 500, the electro-optical element 300 of the embodiment is employed as the electro-optical element 400, the same beneficial effect as that of the electro-optical element 400 can be achieved. This applies to the examples explained below with reference to Fig. 16 and Fig. 17 in the same manner.

1. Construction of the electro-optical element

In the optical module 500, the first electro-optical element 400a and the second electro-optical element 400b are provided to face an end face 30a and an end face 30b, respectively, of the optical waveguide 30 as shown in FIG. 14. The first and the second electro-optical element 400 have the same structure. The first and the second electro-optical element 400 include the light-emitting part 340 and the light-receiving part 320. Each layer forming the light-emitting part 340 and the light-receiving part 320 has nearly the same construction as in the light-emitting part 140 and the light-receiving part 120 of the electro-optical element 100 shown in FIG. 1 with the exception of the placement position of the electrode. In FIG. 14, the individual layers of the light-emitting part 340 and the light-receiving part 320 do not have reference signs.

In the electro-optical element 400 shown in FIG. 14, a first electrode 307 and a second electrode 309 function in order to drive the light-emitting part 340. The second electrode 309 and the fourth electrode 310 function in order to drive the light-receiving part 320. An opening 314 is formed at a part of a region of the fourth electrode 310 located on the light-receiving part 320. The bottom of the opening 314 is an optical surface 308.

An optical member 360 is formed on the optical surface 308. The optical member 360 is made of the same material and can be formed as the same manner as the optical member 160 of the electro-optical element 100 shown in FIG. 1. As for the first electrode 307 through the fourth electrode 310, a part of each of which is formed on an insulating layer 306. It is preferable that the insulating layer 306 is a resin such as a polyimide-type resin, a fluorocarbon-type resin, an acrylic-type resin, an epoxy-type resin or the like, or an insulating material such as silicon nitride, silicon oxide, silicon nitride oxide or the like.

Each of the first electro-optical element 400a and the second electro-optical element 400b functions as a light-receiving element or a light-emitting element respectively. The optical module 500 makes a bi-directional communication possible. If the first electro-optical element 400a functions as the light-emitting element and the second electro-optical element 400b functions as the light-receiving element, the light generated in the light-emitting part 340 of the first electro-optical element 400a emits from the optical surface 308 and is incident on the optical member 360. Then, the light emits from the optical member 360 in which the light is condensed and is incident on the end face 30a of the optical fiber 30. The incident light transmits through the optical fiber 30 so as to exit from the end face 30b. Subsequently, the light is incident on the optical surface 308 of the second electro-optical element 400b after passing through the optical member 360. Then, the light is absorbed in the light-receiving part 320 of the second electro-optical element 400b.

Alternatively, if the first electro-optical element 400a functions as the light-receiving element and the second electro-optical element 400b functions as the light-emitting element, the light generated in the light-emitting part 340 of the first electro-optical element 400b emits from the optical surface 308 and is incident on the optical member 360. Then, the light emits from the optical member 360 in which the light is condensed and is incident on the end face 30b of the optical fiber 30. The incident light transmits through the optical fiber 30 so as to exit from the end face 30a. Subsequently, the light is incident on the optical surface 308 of the second electro-optical element 400a after passing through the optical member 360. Then, the light is absorbed in the light-receiving part 320 of the second electro-optical element 400a.

The relative position of the first electro-optical element 400a with respect to the end face 30a of the optical fiber 30 is fixed. The relative position of the first electro-optical element 400b with respect to the end face 30b of the optical fiber 30 is fixed. The optical surface 308 of the first electro-optical element 400a faces the end face 30a of the optical fiber 30. The optical surface 308 of the first electro-optical element 400b faces the end face 30b of the optical fiber 30.

The semiconductor chip 20 is provided in order to drive the respective electro-optical element 400. Namely, the semiconductor chip 20 includes a circuit in order to drive the electro-optical element 400. Each wiring pattern 24, 34, 64 that is electrically connected to an inner circuit is provided in multiple numbers on the semiconductor chip 20.

The semiconductor chip 20 and the electro-optical element 400 are electrically connected. For example, the first electrode 307 and the wiring pattern 24 are electrically connected by a solder 26. Also, the second electrode 309 and the wiring pattern 64 are electrically connected by solder 26. Additionally, the fourth electrode 310 and the wiring pattern 34 are electrically connected by solder 26.

In the electro-optical element 400, the semiconductor chip 20 can be face-down mounted.

Accordingly, the solder not only connects the electro-optical element 400 and the semiconductor chip 20 electrically but also to fixes them to one another. As for the connection between the electrodes described above and the wiring pattern, a wire or a conductive adhesive may be used instead of using the solder 26.

Also, an interstice between the electro-optical element 400 and the semiconductor chip 20 can be fixed by using a resin 56 as shown in FIG. 14. Thus, the resin 56 has a function that keeps a connecting condition between the electro-optical element 400 and the semiconductor chip 20. In this case, preventing the optical member 360 from becoming covered by the resin 56, the refractive index difference between the optical member 311 and its surrounding can be maintained, thereby ensuring a light condensing function of the optical member 360.

A hole 28 (for example, a through hole) is provided in the semiconductor chip 20. The optical fiber 30 is inserted into the hole 28. The hole 28 goes through the semiconductor chip 20 from the surface on which the wiring patterns 24, 34, 64 are provided to its opposite surface while avoiding the inner circuit. A taper (not shown) may be provided at least at one of an opening edges of the hole. With providing the taper, the optical fiber can be inserted easily into the hole 28.

2. Method for driving the optical module.

The method of driving the optical module 500 shown in FIG. 14 will be described with reference to FIG. 15. FIG. 15 is a diagram schematically illustrating an example of a drive circuit (a principal part) for the electro-optical elements 400 shown in FIG. 14.

In the optical module 500 shown in FIG. 14, a control is carried out so as to interchange a light-transmitting and a light-receiving by time-sharing. As above-mentioned, if the first electro-optical element 400a functions as the light-emitting element, the control is carried out such that the second electro-optical element 400b receives the light generated in the first light-emitting element 400a. If the second electro-optical element 400b functions as the light-emitting element, the control is carried out such that the first electro-optical element 400a receives the light generated in the second light-emitting element 400b. The time-sharing is controlled by a clock 54 and a clock 55 that are input into a driver IC 40 and a switching circuit 42 respectively.

The drive circuit for the electro-optical element 400 includes the driver IC 40, the switching circuit 42, and a trans-impedance amplifier (TIA) 44 as shown in FIG. 15. The drive circuit shown in FIG. 15 is provided for every electro-optical element 400. Additionally, in the electro-optical element 400, a bias can be applied for the light-emitting part 340 and the light-receiving part 320 in the same direction.

The driver IC is electrically connected to one electrode of the light-emitting part 340 of the electro-optical element 400. The switching circuit 42 is electrically connected to one electrode of the light-receiving part 320 of the electro-optical element 400. On the other hand, another electrode of the light-emitting part 340 and another electrode of the light-receiving part 320 are grounded as shown in FIG. 15. In addition, a reverse bias is applied to the one electrode of the light-receiving part 320. The TIA 44 is electrically connected to the switching circuit 42.

The driver IC 40 is provided in order to drive the light-emitting part 340 of the electro-optical element 400. Specifically, the light generated in the light-emitting part 340 emits while a transmitting signal 58 is input into the driver IC 40. The light-receiving part 320 can monitor the output of the light generated in the light-emitting part 340 while the light-emitting part 340 is under operation. Referring to FIG. 15, a method of driving the optical module will be more specifically described below.

If the transmitting signal 58 is input into the driver IC 40, the driver IC 40 starts to drive the light-emitting part 340. While the transmitting signal 58 is input into the driver IC 40, the output of the light generated in the light-emitting part 340 is detected by the light-receiving part 320. The output of the light detected is input into the driver IC 40 as an APC (automatic power control) input 52 by the switching circuit 42.

On the other hand, while the transmitting signal 58 is not input into the driver IC 40, the light exited from the end face 30a of the optical fiber 30 is incident on the optical surface 108 of the electro-optical element 400 after passing through the optical member 160. Specifically, while the transmitting signal 58 is not input into the electro-optical element 400, the switching circuit 42 is switched to the TIA 44 side (refer to FIG. 15). The TIA 44 has a function of amplifying the receiving signal 50.

As above-mentioned, in the optical module 500, the first electro-optical element 400a and second electro-optical element 400b can be controlled by time-sharing such that if the first electro-optical element 400a is under a light-emitting state, the second electro-optical element 400b is in a light-receiving state, and if the first electro-optical element 400a is under a light-receiving state, the second electro-optical element 400b is in a light-emitting state.

FIG. 16 is a diagram illustrating an optical transmitting device as another example of using the invention. An optical transmitting device 90 interconnects electronic apparatuses 92 such as a computer, a display, a storage device, a printer or the like. The electronic apparatuses 92 may be information-communication apparatuses. The optical transmitting device 90 may include a plug 96 provided at both ends of a cable 94. The cable 94 includes the optical fiber 30 (refer to FIG. 14). The plug 96 includes the electro-optical element 400 (400a, 400b) and the semiconductor chip 20. Therefore, these elements are not visible in FIG. 16. A fixing condition between the optical fiber and the electro-optical element 400 is the same as that described above.

The electro-optical elements 400a and 400b are provided at both end parts of the optical fiber 30, respectively. If the electro-optical element 400a provided at one end of the optical fiber 30 functions as the light-receiving element, after converting a light signal to an electrical signal in the light-receiving part 120 of the electro-optical element 400a, the electrical signal is input into the electronic apparatus 92. In this case, the electro-optical element 400b provided at another end part of the optical fiber 30 functions as the light-emitting element. Thus, the electrical signal output from the electronic apparatus 92 is converted to an optical signal in the light-emitting part 140 of the electro-optical element 400b. The optical signal transmits through the optical fiber 30 and is input into the electro-optical element 400a functioning as the light-receiving element.

As mentioned above, with the optical transmitting device 90, communication among the electronic apparatuses 92 can be achieved by the light signal.

FIG. 17 is a diagram illustrating a usage of an optical transmitting device. The optical transmitting device 90 is connected among electronic apparatuses 80. As for the electronic apparatuses, a liquid crystal display monitor or a digital CRT (may be used in field of financial, mail-order, medical care, education), a liquid crystal projector, a plasma display (PDP), a digital TV, a cash register for retailer (for point of sales scanning (POS)), a video recorder, a tuner, a game device, a printer or the like are exemplified.

In the electro-optical element of the above-mentioned embodiment, while a case where the light-emitting part includes one columnar part has been described, even if plural columnar parts are provided in the light-emitting part, this does not adversely affect the embodiment of the invention. Also, if plural electro-optical elements are provided in an array, this includes the same effect.

In addition, in the above-mentioned embodiment, the p-type and n-type may be interchanged in the semiconductor layers. In the above-mentioned embodiment, while a case of the AlGaAs has been described, in accordance with the oscillation wavelength, another material system, for example, a semiconductor material such as a GaInP (gallium-indium-phosphide) system, a ZnSSe (zinc-sulfur-selenide) system, an InGaN (indium-gallium-nitride) system, an AlGaN (aluminum-gallium-nitride) system, an InGaAs (indium-gallium-arsenide) system, a GaInAs (gallium-indium-arsenide) system, a GaAsSb (gallium-arsenide-antimony) system are applicable.

**Claims**

1. An electro-optical element, comprising:

   a light-emitting part (140; 340) including a first mirror (102), an active layer (103) provided on the first mirror (102), and a second mirror (104) provided on the active layer (103);
   a light-receiving part (120; 320) including a first contact layer (111), a light absorption layer (112) provided on the first contact layer (111), a second contact layer (113) provided on the light absorption layer (112), and an optical surface (108; 308), which allows light to pass through, the light-receiving part (120; 320) being provided on the light-emitting part (140; 340), light being emitted at least in a direction in that the light-emitting part (140; 340) and the light-receiving part (120; 320) are stacked upon each other; and
   an optical member (160; 360) having the function of changing an optical characteristic or the traveling direction of light, and provided at least on the optical surface (108; 308), wherein the greatest diameter of the projection of the optical member (160; 360) onto the upper surface of the light-receiving part (120; 320) is larger than the greatest diameter of the upper surface of the light-receiving part (120; 320), the upper surface of the light-receiving part being a face of the light-receiving part (120; 320) containing the optical member,

   **characterized in that** the optical thickness d of the light-receiving part (120; 320) is $d = m\lambda/2$, where A is the design wavelength of the light-emitting part (140; 340) and m is a natural number greater than or equal to one.

2. The element according to Claim 1, wherein at least the upper part of the light-receiving part (120; 320) has a columnar shape.

3. The element according to Claim 1 or 2, wherein a cross-sectional surface cut by a plane parallel to the optical surface (108; 308) of the optical member (160; 360) is at least one of a circle and an ellipse.

4. The element according to any of Claims 1 to 3, wherein the optical member (160; 360) is formed by a precursor of an UV curable resin or a thermosetting resin.

5. The element according to Claim 4, wherein the optical member (160; 360) is formed by an acrylic-type UV curable resin or epoxy-type resin or a thermosetting polyimide-type resin.

6. The element according to any of Claims 1 to 5, wherein the light-receiving part (120; 320) is adapted to convert a part of the light emitted from the light-emitting part (140; 340) to a current.

7. The element according to any of Claims 1 to 5, wherein the light-receiving part (120; 320) is adapted to convert the light that is incident on the optical surface (108; 308) from the optical member (160; 360) to a current.

8. The element according to any one of Claims 1 to 7, wherein the light-emitting part (140; 240; 340) is a surface emitting semiconductor laser.

9. The element according to any of Claim 1 to 8, wherein the optical member (160; 360) functions as a lens.

**Patentansprüche**

1. Elektrooptisches Element, aufweisend:

   einen lichtemittierenden Teil (140; 340), der einen ersten Spiegel (102), eine auf dem ersten Spiegel vorgesehene, aktive Schicht (103) und einen auf der aktiven Schicht (103) vorgesehenen, zweiten Spiegel (104) umfaßt;
   einen lichtempfangenden Teil (120; 320), der eine erste Kontaktschicht (111), eine auf der ersten Kontaktschicht (111) vorgesehene Lichtabsorptionsschicht (112), eine zweite, auf der Lichtabsorptionsschicht (112) vorgesehene Kontaktschicht (113) sowie eine optische Oberfläche (108; 308) umfaßt, die Licht durch den auf dem lichtemittierenden Teil (140; 340) vorgesehenen lichtempfangenden Teil (120; 320) hindurchläßt, wobei Licht mindestens in einer Richtung ausgestrahlt wird, in der der lichtemittierende Teil (140; 340) und der lichtempfangende Teil (120; 320) aufeinandergestapelt sind; und
   ein optisches Glied (160; 360), welches die Funktion hat, eine optische Eigenschaft oder die Richtung der Lichtfortpflanzung zu ändern und welches mindestens auf der optischen Oberfläche (108; 308) vorgesehen ist, wobei der größte Durchmesser der Projektion des optischen Gliedes (160; 360) auf die Oberseite des lichtempfangenden Teils (120; 320) größer ist als der größte Durchmesser der Oberseite des lichtempfangenden Teils (120; 320), wobei die Oberseite des lichtempfangenden Teils eine das optische Glied enthaltende Fläche des lichtempfangenden Teils (120; 320) ist,

**dadurch gekennzeichnet, daß** die optische Dicke d des lichtempfangenden Teils (120; 320) d = mλ/2 ist, worin λ die Sollwellenlänge des lichtemittierenden Teils (140; 340) und m eine natürliche Zahl größer als oder gleich Eins ist.

2. Element nach Anspruch 1, bei dem mindestens der obere Teil des lichtempfangenden Teils (120; 320) säulenförmige Gestalt hat.

3. Element nach Anspruch 1 oder 2, bei dem die von einer Ebene parallel zur optischen Oberfläche (108; 308) des optischen Gliedes (160; 360) geschnittene Querschnittsfläche mindestens entweder ein Kreis oder eine Ellipse ist.

4. Element nach einem der Ansprüche 1 bis 3, bei dem das optische Glied (160; 360) von einem Vorläufer eines ultraviolett härtbaren Harzes oder eines duroplastischen Harz gebildet ist.

5. Element nach Anspruch 4, bei dem das optische Glied (160; 360) von einem ultraviolett härtbaren Harz der Acrylart oder einem Harz der Epoxyart oder einem durch Wärme härtbaren Harz der Polyimidart gebildet ist.

6. Element nach einem der Ansprüche 1 bis 5, bei dem der lichtempfangende Teil (120; 320) einen Teil des vom lichtemittierenden Teil (140; 340) ausgestrahlten Lichts in einen Strom umwandeln kann.

7. Element nach einem der Ansprüche 1 bis 5, bei dem der lichtempfangende Teil (120; 320) das vom optischen Glied (160; 360) auf die optische Oberfläche (108; 308) einfallende Licht in einen Strom umwandeln kann.

8. Element nach einem der Ansprüche 1 bis 7, bei dem der lichtemittierende Teil (140; 240; 340) ein Halbleiterlaser mit Oberflächenemission ist.

9. Element nach einem der Ansprüche 1 bis 8, bei dem das optische Glied (160; 360) als Linse wirkt.

**Revendications**

1. Elément électro-optique, comprenant :

une partie (140 ; 430) émettant de la lumière comprenant un premier miroir (102), une couche (103) active prévue sur le premier miroir (102) et un deuxième miroir (104) prévu sur la couche (103) active ;
une partie (120 ; 320) recevant de la lumière comprenant une première couche (111) de contact, une couche (112) d'absorption de la lumière prévue sur la première couche (111) de contact et une deuxième couche (113) de contact prévue sur la couche (112) d'absorption de la lumière et une surface (108 ; 308) optique qui permet à de la lumière de la traverser, la partie (120 ; 320) recevant de la lumière étant prévue sur la partie (140 ; 340) émettant de la lumière, de la lumière étant émise au moins dans une direction dans laquelle la partie (140 ; 340) émettant de la lumière et la partie (120 ; 320) recevant de la lumière sont empilées l'une sur l'autre ; et
un élément (160 ; 360) optique ayant la fonction de modifier une caractéristique optique ou la direction de propagation de la lumière est prévu au moins sur la surface (108 ; 308) optique, le diamètre le plus grand de la projection de l'élément (160 ; 360) optique sur la surface supérieure de la partie (120 ; 320) recevant de la lumière étant plus grand que le diamètre le plus grand de la surface supérieure de la partie (120 ; 320) recevant de la lumière, la surface supérieure de la partie recevant de la lumière étant une face de la partie (120; 320) recevant de la lumière contentant l'élément optique,

**caractérisé en ce que** l'épaisseur optique de la partie (120 ; 320) recevant de la lumière est d = mλ/2, λ étant la longueur d'onde de conception de la partie (140 ; 340) émettant de la lumière et m étant un nombre naturel supérieur ou égal à un.

2. Elément suivant la revendication 1, dans lequel au moins la partie supérieure de la partie (120 ; 320) recevant de la lumière a la forme d'une colonne.

**3.** Elément suivant la revendication 1 ou 2, dans lequel une surface de section transversale coupée par un plan parallèle à la surface (108 ; 308) optique de l'élément (160 ; 360) optique est au moins l'un d'un cercle et d'une ellipse.

**4.** Elément suivant l'une quelconque des revendications 1 à 3, dans lequel l'élément (160 ; 360) optique est formé par un précurseur d'une résine pouvant être durcie par les UV ou d'une résine thermodurcissable.

**5.** Elément suivant la revendication 4, dans lequel l'élément (160 ; 360) optique est formé d'une résine de type axcrylique pouvant être durcie par les UV ou d'une résine de type époxy ou d'une résine thermodurcissable de type polyimide.

**6.** Elément suivant l'une quelconque des revendications 1 à 5, dans lequel la partie (120 ; 320) recevant de la lumière est conçue pour transformer une partie de la lumière émise par la partie (140 ; 340) émettant de la lumière en un courant.

**7.** Elément suivant l'une quelconque des revendications 1 à 5, dans lequel la partie (120 ; 320) recevant de la lumière est conçue pour transformer la lumière qui est incidente sur la surface (108 ; 308) optique en provenant de l'élément (160 ; 360) optique en un courant.

**8.** Elément suivant l'une quelconque des revendications 1 à 7, dans lequel la partie (140 ; 240 ; 340) émettant de la lumière est un laser à semi-conducteur émettant par la surface.

**9.** Elément suivant l'une quelconque des revendications 1 à 8, dans lequel l'élément (160 ; 360) optique fonctionne en tant que lentille.

# F I G. 1

F I G. 2

F I G. 3

# F I G. 4

R1
113
112
111
104
103
102
101

# F I G. 5

113
R2
112
120
111
104
103
102
101

FIG. 6

FIG. 7

F I G.  8

F I G.  9

# F I G. 1 0

## FIG. 11

## FIG. 12

F I G. 13

design wavelength $\lambda$ : 850 nm

F I G. 17

F I G. 14

F I G. 15

F I G. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10135568 A
- US 20020185588 A1
- JP 2000269585 A
- US 6001664 A
- EP 0760544 A1
- US 20020044582 A

**Non-patent literature cited in the description**

- **LIU Y et al.** Chip-scale integration of VCSEL, photodetector, and microlens arrays. *PROCEEDINGS OF THE SPIE,* 2002, vol. 4652, 11-18